# EUROPEAN PATENT APPLICATION

(11) **EP 2 498 586 A2**
(43) Date of publication of application: **12.09.2012**
(21) Application number: 12158691.1
(22) Date of filing: 09.03.2012
(51) Int. Cl.: H05K 1/11

(54) **Flexible Flat Cable and Image Display Device**

(30) Priority: 11.03.2011 JP 2011054792
(71) Applicant: Funai Electric Co., Ltd., Osaka 574-0013 (JP)
(72) Inventor: Ishino, Yusuke, Daito-shi, Osaka 574-0013 (JP); Kawai, Yasuhiko, Daito-shi, Osaka 574-0013 (JP)
(74) Representative: Grünecker, Kinkeldey, Stockmair & Schwanhäusser

(57) **Abstract**

A flexible flat cable includes a cable main body and a pair of reinforcing plates. The cable main body includes a pair of resin films and a plurality of linear conductors. The linear conductors are exposed with respect to one of the resin films to form longitudinally extending electrical terminals. Each of the reinforcing plates has a fixed end section. The fixed end sections are fixedly coupled to end portions of the cable main body on the other of the resin films, respectively. The fixed end sections define a pair of bending lines such that the end portions of the cable main body are bendable relative to a middle portion of the cable main body to form acute corners between the end portions and the middle portion, respectively.

## Description

### CROSS-REFERENCE TO RELATED APPLICATIONS

This application claims priority to Japanese Patent Application No. 2011-054792 failed on March 11,2011. The entire disclosure of Japanese Patent Application No. 2011-054792 is hereby incorporated herein by reference.

### BACKGROUND

### Field of the Invention

The present invention generally relates to a flexible flat cable. More specifically, the preset invention relates to a flexible flat cable which electrically connects printed wiring boards. Furthermore, the present invention also relates to an image display device in which the flexible flat cable is provided.

### Description of the Related Art

A conventional flexible flat cable for electrically connecting adjacent printed wiring boards includes a plurality of aligned, linear conductors and electrically insulating upper and lower resin films that cover the linear conductors. Terminals are formed by exposing both ends of the linear conductors at cut-outs at both ends of one of the resin films. Reinforcing plates are affixed over the resin film at both ends.

With another conventional flexible flat cable, two distal ends of the flexible flat cable where reinforcing plates are affixed are bent at a right angle. The two ends of the flexible flat cable are connected by being plugged into open-and-close type of connectors. The distal end bent parts at both ends are fitted into concave components of the connectors such that the two ends will not come loose from the connectors (see Japanese Laid-Open Patent Application Publication No. 2006-66327, for example). With further another conventional flexible flat cable, reinforcing plates are affixed to both ends of the flexible flat cable. The reinforcing plates are slightly longer than fitting length of connectors. The flexible flat cable is bent in a U-shape at end faces of the reinforcing plates. The bent parts are pushed in and inserted into the connectors (see Japanese Laid-Open Patent Application Publication No. H9-148010, for example). With further another conventional flexible flat cable, reinforcing plates are affixed to ends of the flexible flat cable. The ends are bent at a right angle. Protrusions of the reinforcing plates stick out in a lengthwise direction beyond bending positions. The protrusions are held with fingers to allow insertion into and removal from connectors (see Japanese Laid-Open Patent Application Publication No. 2004-171958, for example). With yet another conventional flexible flat cable, a connector connection component is formed on an end of the flexible flat cable. The end of the flexible flat cable is bent at a right angle. A part of the bent portion is cut out so as not to bend, thereby forming a holding component that is used for inserting and removing a connector (see Japanese Laid-Open Utility Model Application Publication No. H3-33982, for example).

### SUMMARY

With the conventional flexible flat cable, the conventional flexible flat cable is used to electrically connect the adjacent printed wiring boards together by inserting the ends of the flexible flat cable (i.e., two ends where the terminals are formed and the reinforcing plates are affixed) from above into the connectors of the printed wiring boards. However, with this conventional flexible flat cable, it has been discovered that the flexible flat cable curves towards a shield plate that is disposed above the cable to block electromagnetic waves. This causes a problem that the flexible flat cable will touch the shield plate, which adversely affects electromagnetic interference (EMI) and electromagnetic sensitivity (EMS).

Also, with this conventional flexible flat cable, the exposed terminals contact with fingers of a worker when the ends of the cable are being inserted into the connectors. Thus, oil from the fingertips tends to adhere to the terminals, and oxidation leads to degradation.

The former problem (i.e., that of contacting with the shield plate) can more or less be solved by widening the distance between the shield plate and the printed wiring boards so that the curved flexible flat cable does not touch the shield plate. However, widening the distance cannot be considered a favorable remedy because it is contrary to the need to reduce the thickness of the image display devices, such as liquid crystal television sets. In light of this, it has been discovered that there has been a need for a flexible flat cable that will curve downward, without the middle portion curving upward, when two ends are inserted from above into connectors.

Furthermore, it has been also discovered that the latter problem (i.e., that of oil from the fingertips adhering to the terminals) can be solved if protrusions or holding components for aiding in connector insertion and removal are formed, and these components are grasped by the fingers such that the two ends of the flexible flat cable can be inserted into the connectors.

An improved flexible flat cable was conceived in light of the above-mentioned problem. One object of the present disclosure is to provide a flexible flat cable with which a middle portion of the flexible flat cable is prevented from contacting other parts of an image display device when the flexible flat cable is installed in the image display device.

Another object of the present disclosure is to provide a flexible flat cable with which it is easier to install the flexible flat cable to the image display device and oil from fingertips is less likely to adhere to terminals of the flexible flat cable during installation.

In accordance with one aspect of the present disclosure, a flexible flat cable includes a cable main body and a pair of reinforcing plates. The cable main body includes a pair of resin films and a plurality of linear conductors. The lincar conductors are arranged in parallel to each other between the resin films. The linear conductors are exposed with respect to one of the resin films to form longitudinally extending electrical terminals of the flexible flat cable at end portions of the cable main body, respectively. Each of the reinforcing plates has a fixed end section. The fixed end sections are fixedly coupled to the end portions of the cable main body on the other of the resin films, respectively. The fixed end sections define a pair of bending lines such that the end portions of the cable main body are bendable relative to a middle portion of the cable main body that extends between the end portions of the cable main body to form acute corners between the end portions and the middle portion, respectively.

These and other objects, features, aspects and advantages will become apparent to those skilled in the art from the following detailed description, which, taken in conjunction with the annexed drawings, discloses a preferred embodiment.

### BRIEF DESCRIPTION OF THE DRAWINGS

Referring now to the attached drawings which form a part of this original disclosure:

FIG. 1 is a top plan view of a flexible flat cable in accordance with one embodiment, illustrating end portions of the flexible flat cable being bent relative to a middle portion of the flexible flat cable;

FIG. 2 is a bottom plan view of the flexible flat cable illustrated in FIG. 1;

FIG. 3 is a cross sectional view of the flexible flat cable taken along III-III line in FIG. 1;

FIG. 4 is a cross sectional view of the flexible flat cable in accordance with one embodiment, illustrating the flexible flat cable before the end portions being bent relative to the main portion;

FIG. 5 is a bottom plan view of the flexible flat cable illustrated in FIG. 4, illustrating the flexible flat cable before the end portions being bent relative to the main portion;

FIG. 6 is an enlarged cross sectional view of an image display device in which the flexible flat cable illustrated in FIG. 1 is installed, illustrating a connection between the flexible flat cable and printed wiring boards; and

FIG. 7 is a side elevational view of the image display device in which the flexible flat cable illustrated in FIG. 1 is installed, a cabinet of the image display device broken away to show internal configurations of the image display device.

### DETAILED DESCRIPTION OF EMBODIMENTS

A preferred embodiment will now be explained with reference to the drawings. It will be apparent to those skilled in the art from these disclosures that the following descriptions of the preferred embodiment are provided for illustration only and not for the purpose of limiting the invention as defined by the appended claims and their equivalents.

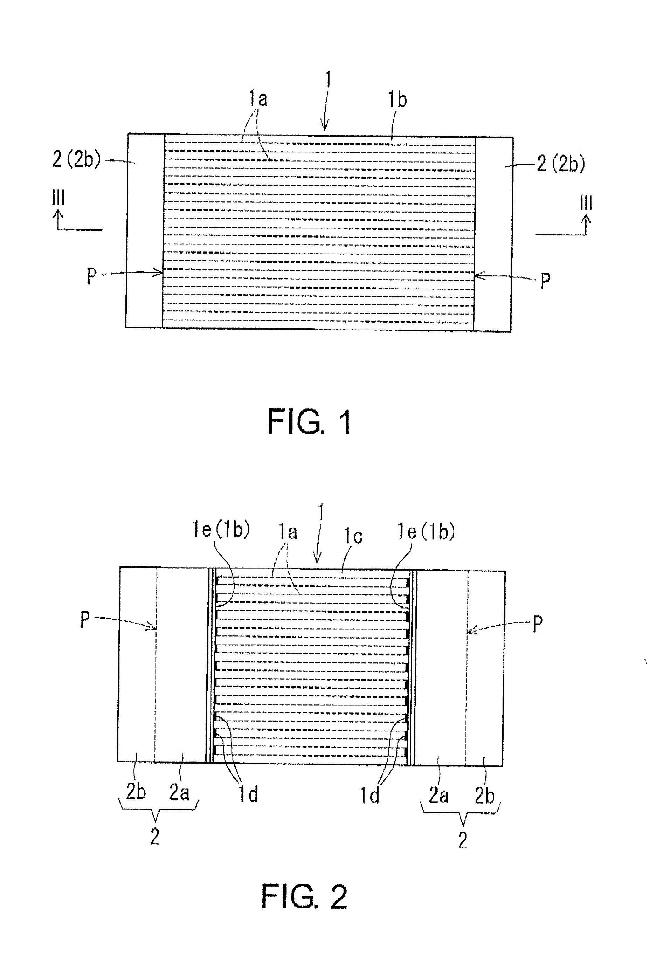

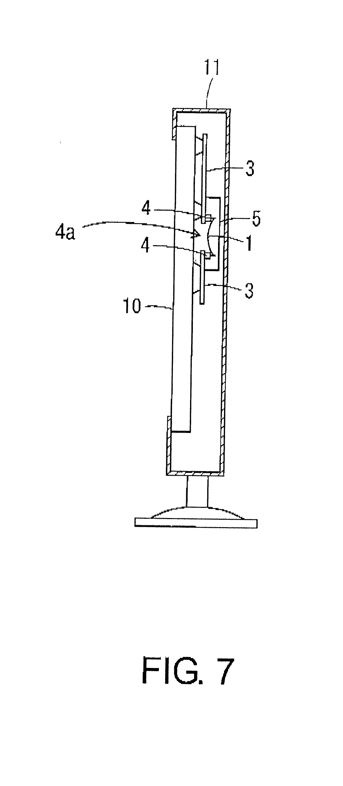

Referring to FIGS. 1 to 7, an image display device having a flexible flat cable 1 in accordance with one embodiment will be described in detail. As illustrated in FIG. 7, the image display device, such as a flat-screen liquid crystal television set, mainly includes the flexible flat cable 1, main and sub printed wiring boards 3 (e.g., a plurality of printed wiring boards) with connectors 4, an electromagnetic shield plate 5, a liquid crystal module 10 (e.g., display module) and a cabinet 11. The flexible flat cable 1 electrically connects the printed wiring boards 3 to each other within the cabinet 11. Specifically, the flexible flat cable I is electrically connected between the connectors 4 of the printed wiring boards 3. The liquid crystal module 10 displays an image. The liquid crystal module 10 is disposed within the cabinet 11 such that the liquid crystal module 10 faces a front opening of the cabinet 11. The liquid crystal module 10 mainly includes a backlight unit, a rear frame and a liquid crystal panel. The configuration of the liquid crystal module 10 is well known. Thus, the detailed description about the liquid crystal module 10 is omitted for the sake of brevity. The backlight unit is provided inside the rear frame. The liquid crystal panel is disposed on a front face side of the rear frame. The printed wiring boards 3 are attached adjacent to each other on convex components formed in a rear face of the rear frame of the liquid crystal module 10. The connectors 4 are disposed on the printed wiring boards 3 at mutually opposing positions of the printed wiring boards 3, respectively. As illustrated in FIG. 7, the connectors 4 protrude rearward of the image display device relative to the printed wining boards 3, respectively. The electromagnetic shield plate 5 disposed opposite the flexible flat cable 1. The electromagnetic shicld plate 5 covers the flexible flat cable 1. The electromagnetic shield plate 5 is attached to the printed wiring boards 3 spanning between the printed wiring boards 3. Specifically, the electromagnetic shield plate 5 is disposed rearward of the image display device relative to the printed wiring boards 3 such that the electromagnetic shield plate 5 covers the flexible flat cable 1 from a rear side of the image display device.

Referring to FIGS. 1 to 5, the flexible flat cable 1 will be described in detail. The flexible flat cable 1 includes a cable main body and a pair of reinforcing plates 2. The cable main body mainly has a plurality of linear conductors 1 a and upper and lower resin films 1b and 1c. The linear conductors 1a are aligned in parallel to each other. The linear conductors 1a are disposed between the resin films 1b and 1c, and are covered with the resin films 1b and 1c. The resin films 1b and 1c are made of electrically insulating material. The lower resin film 1c (e.g., one of the resin films) has cut-out portions 1g at both lengthwise ends of the lower resin film 1c such that end portions of the linear conductors 1 a are exposed with respect to the lower resin film 1c through the cut-out portions 1g to form longitudinally extending electrical terminals 1d of the flexible flat cable 1.

The linear conductors 1a are made of soft copper foil plated with tin. The linear conductors 1 a are formed as extremely thin wires. The linear conductors 1a are arranged in parallel rows at a specific pitch in a widthwise direction of the flexible flat cable 1. The resin films 1b and 1c cover the linear conductors 1a. The resin films 1b and 1c are polyester films, polyolefin films, or the like having a specific thickness. The resin films 1b and 1c are integrated by thermocompression bonding with the linear conductors 1 a in between.

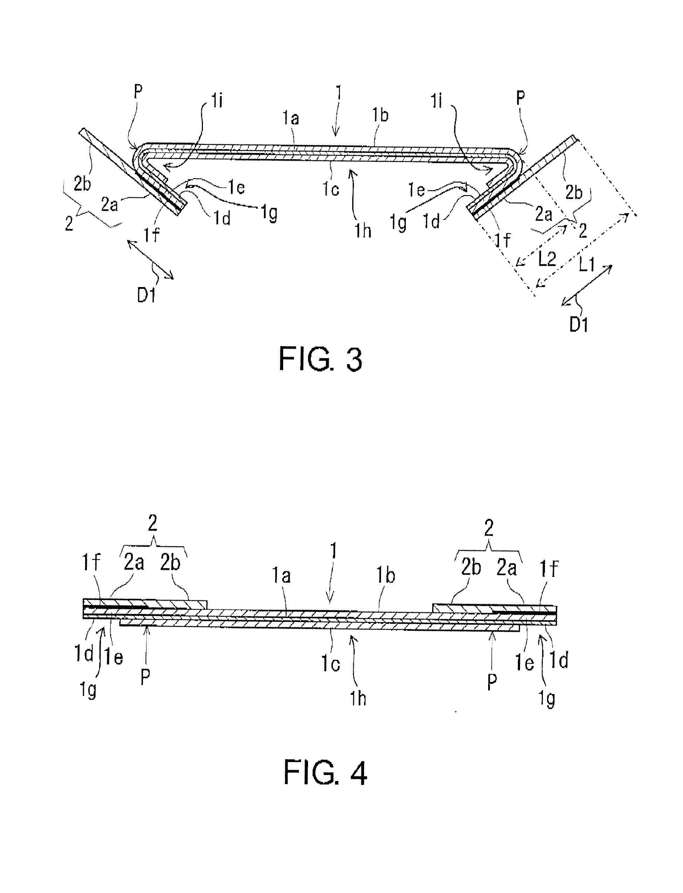

The flexible flat cable 1 further includes a pair of end portions 1e at both ends in a lengthwise direction of the flexible flat cable 1 and a middle portion 1h extending between the end portions 1e. The lengthwise direction is perpendicular to the widthwise direction. The end portions 1e are bendable relative to the middle portion 1h such that the end portions 1e and the middle portion 1h form acute corners 1i therebetween, respectively. Specifically, the end portions 1e are bent at an acute angle relative to the middle portion 1h towards the lower resin film 1c to form bent ends. The end portions 1e are bent at bending positions P that are closer to a midst point of the flexible flat cable 1 in the lengthwise direction than the terminals 1d. The reinforcing plates 2 are affixed with an adhesive agent 1f on the upper resin film 1b at the end portions 1e.
The reinforcing plates 2 serve to reinforce the end portions 1e of the flexible flat cable 1 such that the end portions 1e of the flexible flat cable 1 on which the terminals 1d are formed do not buckle when the end portions 1e are inserted into the connectors 4, respectively. The reinforcing plates 2 also serve as grips that are grasped by fingertips of a worker to make an insertion or removal work easier. As illustrated in FIG. 3, the reinforcing plates 2 are longer than the end portions le in first directions D1 of the end portions 1e along which the linear conductors 1a extend at the end portions 1e, respectively. Specifically, the reinforcing plates 2 have a first length L1 in the first directions D1 of the end portions 1e, respectively The end portions 1e have a second length L2 in the first directions D1 of the end portions 1e, respectively. The first length L1 of the reinforcing plates 2 is greater than the second length L2 of the end portions 1c. Each of the reinforcing plates 2 has a fixed end section 2a and a free end section 2b. The fixed end sections 2a are superposed over the upper resin film 1b at the end portions 1e, respectively. The fixed end sections 2a are affixed to the upper resin film 1b (e.g., the other of the resin films) at the end portions 1e with the adhesive agent 1f to reinforce the end portions 1e. Specifically, the fixed end sections 2a are fixedly coupled to the end portions 1e, respectively, such that each of the fixed end sections 2a has an end edge that is aligned to an end edge of corresponding one of the end portions 1e. The free end sections 2b are arranged relative to the fixed end sections 2a, respectively. The free end sections 2b of the reinforcing plates 2 become grips that stick out from the end portions 1e beyond the bending positions P and the acute corners 1i, respectively. The free end sections 2b are free from directly coupling to the upper resin films 1b, respectively. It is preferable for the reinforcing plates 2 to be made of polyester tape or the like with a strength having a thickness of about 0.2 to 0,3 mm. Furthermore, the reinforcing plates 2 are preferably about 2 to 5 mm longer than the end portions 1e (i.e., The first length L1 is about 2 to 5 mm longer than the second length L2), and are made from a material that is easy to grasp with fingertips. The reinforcing plates 2 are affixed to the upper resin film 1b of the flexible flat cable 1 to define a pair of transverse bending lines occurring at the bending positions P as seen in FIGS. 2 and 3. Due to the properties of the materials of the linear conductors 1a and the resin films 1b and 1c, the flexible flat cable 1 has a predetermined bending radius such that the bending lines occur at the bending positions P, which are spaced from attachment area formed by the adhesive agent 1f. Thus, the positions of the bending lines depend on the properties of the materials of the linear conductors 1a and the resin films 1b and 1c.

As shown in FIG. 4, the flexible flat cable I is formed as follows. In a state in which the end portions 1e in the lengthwise direction are flat relative to the middle portion 1h (i.e., prior to being bent at the bending positions P that is closer to the midst point than the terminals 1d), one end portions (i.e., fixed end sections 2a or outer end portions) of the reinforcing plates 2 are affixed with the adhesive agent 1f to the upper resin film 1b at the end portions 1e. The other end portions (i.e., free end sections 2b or inner end portions) of the reinforcing plates 2 are left loose without being affixed. Furthermore, as shown in FIG. 3, the end portions 1e are bent at an acute angle to the lower resin film 1c side at the bending positions P.

There are no particular restrictions on the angle at which the end portions 1e (i.e., two ends) are bent, so long as it is an acute angle. However, the larger is the bending angle and the closer it is to being a right angle, the less stress will try to curve the middle portion of the flexible flat cable 1 downward when the end portions 1e are oriented vertically and inserted from above into the connectors 4. Thus, the bending angle of 60° or less is preferable, 45° or less is better, and 30° or less is better yet.

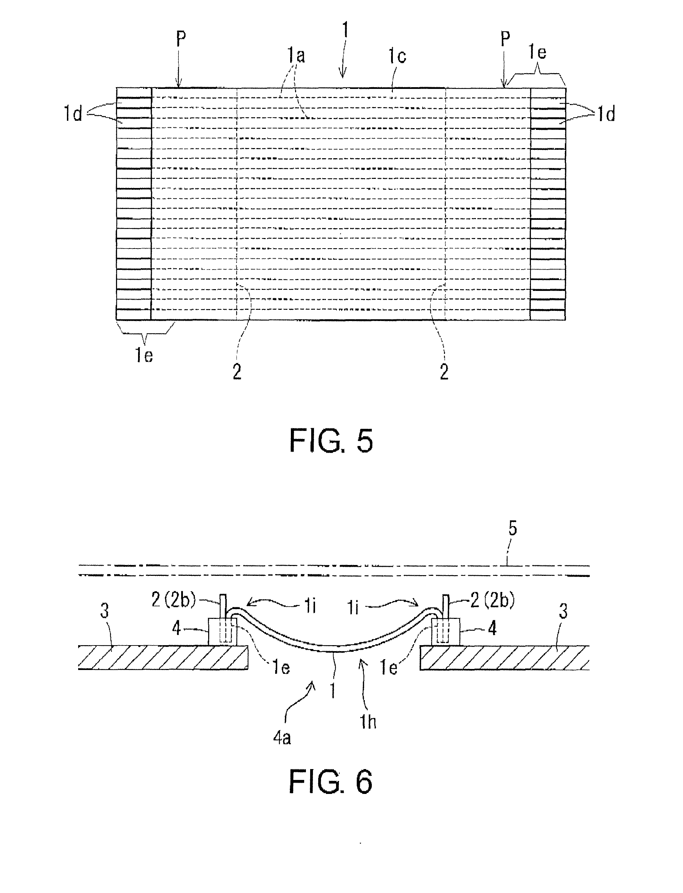

When the flexible flat cable 1 electrically connects two printed wiring boards 3 to each other, the free end sections 2b that stick out from the reinforcing plates 2 and serve as grips are grasped with the fingertips. Then, the end portions 1e where the terminals 1d are exposed are put into a vertical orientation relative to the printed wiring boards 3, respectively, and as shown in FIG. 6 the end portions 1e are inserted from above into the connectors 4 of the printed wiring boards 3. When the end portions 1e of the flexible flat cable 1 are thus inserted from above into the connectors 4, since the end portions 1e are bent at an acute angle, downward stress is exerted on the middle portion 1h of the flexible flat cable 1 excluding the end portions 1e. Then, the middle portion 1h of the flexible flat cable 1 curves downward towards the printed wiring boards 3 as shown in FIG. 6. Therefore, even if the shield plate 5 or the like is disposed above the flexible flat cable 1, there will be little risk that the flexible flat cable 1 will contact with the shield plate 5 or the like and adversely affect electromagnetic interference (EMI) or electromagnetic sensitivity (EMS). As a result, the height at which the shield plate 5 or the like is disposed can be set considerably lower than in the past.

Also, the free end sections 2b of the protruding reinforcing plates 2 are grasped by the fingertip, and the end portions 1e are inserted into or removed from the connectors 4. Thus, the work of inserting or removing the end portions 1e will be easier, and furthermore it will be less likely that oil from the fingertips will adhere to the exposed terminals 1d of the end portions 1e. As a result, there is less oxidation and degradation of the terminals 1d by this oil.

As illustrated FIG. 7, with the image display device, this flexible flat cable 1 is used to electrically connect the printed wiring boards 3 to each other. Specifically, as shown in FIGS. 6 and 7, the end portions 1e of the flexible flat cable 1 and the reinforcing plates 2 that are affixed to the end portions 1e, arc inserted in a direction perpendicular to the printed wiring boards 3 into the connectors 4, which electrically connects the printed wiring boards 3 to each other. The middle portion 1h of the flexible flat cable 1 excluding the end portions 1e curves toward the side of the printed wiring boards 3. In other words, the middle portion 1h curves away from the electromagnetic shield plate 5 that covers the flexible flat cable 1 and forward of the image display device relative to the acute corners 1i. In particular, the printed wiring boards 3 are arranged spaced apart from each other with a spacing 4a therebetween. The middle portion 1h of the cable body curves towards the spacing 4a between the printed wiring boards 3.

As discussed above, with this liquid crystal television set, the middle portion 1h of the flexible flat cable 1 excluding the end portions 1e curves to the side of the printed wiring boards 3. Thus, the shield plate 5 attached spanning the printed wiring boards 3 does not touch the flexible flat cable 1. As a result, there is little risk of adversely affecting electromagnetic interference (EMI) or electromagnetic sensitivity (EMS). Furthermore, since the height or the thickness of the shield plate 5 can be set considerably smaller than in the past, the liquid crystal television set can be made even thinner.

### GENERAL INTERPRETATION OF TERMS

In understanding the scope of the present invention, the term "comprising" and its derivatives, as used herein, are intended to be open ended terms that specify the presence of the stated features, elements, components and groups, but do not exclude the presence of other unstated features, elements, components and groups. The foregoing also applies to words having similar meanings such as the terms, "including", "having" and their derivatives. Also, the terms "part," "section," "portion," "member" or "element" when used in the singular can have the dual meaning of a single part or a plurality of parts.

While selected embodiments have been chosen to illustrate the present invention, it will be apparent to those skilled in the art from these disclosures that various changes and modifications can be made herein without departing from the scope of the invention as defined in the appended claims. Furthermore, the foregoing descriptions of the selected embodiments according to the present invention are provided for illustration only, and not for the purpose of limiting the invention as defined by the appended claims and their equivalents.

## Claims

1. A flexible flat cable comprising:
a cable main body with a pair of resin films and a plurality of linear conductors, the linear conductors being arranged in parallel to each other between the resin films, the linear conductors being exposed with respect to one of the resin films to form longitudinally extending electrical terminals of the flexible flat cable at end portions of the cable main body, respectively; and
a pair of reinforcing plates each having a fixed end section, the fixed end sections being fixedly coupled to the end portions of the cable main body on the other of the resin films, respectively, the fixed end sections defining a pair of bending lines such that the end portions of the cable main body are bendable relative to a middle portion of the cable main body that extends between the end portions of the cable main body to form acute corners between the end portions and the middle portion, respectively.

2. The flexible flat cable according to claim 1, wherein
each of the reinforcing plates further has a free end section, the free end sections being arranged relative to the fixed end sections, respectively, the free end sections being free from directly coupling to the other of the resin films, respectively.

3. The flexible flat cable according to claim 1 or claim 2, wherein
the resin films are made of electrically insulating material.

4. The flexible flat cable according to any of claims 1 to 3, wherein
the reinforcing plates have a first length in first directions of the end portions along which the linear conductors extend at the end portions of the cable main body, respectively,
the end portions have a second length in the first directions of the end portions, respectively, the first length of the reinforcing plates being greater than the second length of the end portions.

5. An image display device comprising:
a cabinet;
a display module disposed within the cabinet;
a pair of printed wiring boards disposed within the cabinet, the printed wiring boards having connectors; and
a flexible flat cable electrically connected between the connectors of the printed wiring boards, the flexible flat cable including
a cable main body with a pair of resin films and a plurality of linear
conductors, the linear conductors being arranged in parallel to each other between the resin films, the linear conductors being exposed with respect to one of the resin films to form longitudinally extending electrical terminals of the flexible flat cable at the end portions of the cable main body, respectively, the end portions of the cable main body being coupled to the connectors, respectively, such that the end portions and a middle portions of the cable main body that extends between the end portions form acute corners therebetween, respectively; and
a pair of reinforcing plates each having a fixed end section, the fixed end
sections being fixedly coupled to the end portions of the cable main body on the other of the resin films, respectively.

6. The image display device according to claim 5, wherein
the end portions of the cable main body extend perpendicular to the printed wiring boards, respectively, with the middle portion of the cable main body curving towards the printed wiring boards.

7. The image display device according to claim 5 or claim 6, wherein
each of the reinforcing plates further has a free end section, the free end sections being arranged relative to the fixed end sections, respectively, the free end sections being free from directly coupling to the other of the resin films, respectively.

8. The image display device according to any of claims 5 to 7, wherein
the resin films are made of electrically insulating material.

9. The image display device according to any of claims 5 to 8, wherein
the reinforcing plates have a first length in first directions of the end portions along which the linear conductors extend at the end portions of the cable main body, respectively,
the end portions have a second length in the first directions of the end portions, respectively, the first length of the reinforcing plates being greater than the second length of the end portions.

10. The image display device according to claim 9, wherein
the reinforcing plates extend perpendicular to the printed wiring boards beyond the acute corners between the middle portion and the end portions, respectively.

11. The image display device according to claim 9, wherein
the reinforcing plates are coupled to the connectors of the printed wiring boards with the end portions of the cable main body.

12. The image display device according to any of claims 5 to 11, further comprising
a shield plate disposed opposite the flexible flat cable, the middle portion of the cable main body curving away from the shield plate.

13. The image display device according to any of claims 5 to 12, wherein
the connectors of the printed wiring boards protrude rearward of the image display device relative to the printed wiring boards, the middle portion of the cable main body curving forward of the image display device relative to the acute corncrs.

14. The image display device according to any of claims 5 to 13, wherein
the printed wiring boards are arranged spaced apart from each other with a spacing therebetween, the middle portion of the cable main body curving towards the spacing between the printed wiring boards.

15. The image display device according to any of claims 5 to 14, wherein each of the fixed end sections has an end edge that is aligned to an end edge of corresponding one of the end portions of the cable main body.
